(19) Europäisches Patentamt
European Patent Office
Office européen des brevets

(11) **EP 2 515 396 A1**

(12) **EUROPEAN PATENT APPLICATION**
published in accordance with Art. 153(4) EPC

(43) Date of publication:
**24.10.2012 Bulletin 2012/43**

(51) Int Cl.:
**H01S 5/022** (2006.01)

(21) Application number: **10837293.9**

(86) International application number:
**PCT/JP2010/007301**

(22) Date of filing: **16.12.2010**

(87) International publication number:
**WO 2011/074262 (23.06.2011 Gazette 2011/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.12.2009 JP 2009287703**

(71) Applicant: **Mitsubishi Electric Corporation Tokyo 100-8310 (JP)**

(72) Inventors:
• **TAMAYA, Motoaki**
  **Tokyo 100-8310 (JP)**
• **NANBA, Chise**
  **Tokyo 100-8310 (JP)**

• **YANAGISAWA, Takayuki**
  **Tokyo 100-8310 (JP)**
• **OE, Shinichi**
  **Tokyo 100-8310 (JP)**
• **YAMAMOTO, Shuhei**
  **Tokyo 100-8310 (JP)**
• **YOKOYAMA, Akira**
  **Tokyo 100-8310 (JP)**

(74) Representative: **Sajda, Wolf E. et al Meissner Bolte & Partner GbR Postfach 86 06 24 DE-81633 München (DE)**

(54) **LASER MODULE**

(57) An inexpensive module structure capable of driving an LD array with low stress at a suitable temperature is obtained.

The laser module includes: a heat sink (3) that releases heat from a member in contact with the heat sink (3); a sub-mount substrate (4) that is disposed on the heat sink (3) and made of an insulating material; a feeding layer (5A) that is disposed on the sub-mount substrate (4); and a laser diode array (6) that has a plurality of light-emitting portions disposed on the feeding layer (5A) in a parallel arrangement. A linear expansion coefficient of the sub-mount substrate (4) is made smaller than a linear expansion coefficient of the laser diode array (6), and the linear expansion coefficient of the sub-mount substrate (4) in a state connected to the heat sink (3) having a larger linear expansion coefficient than the laser diode array (6) is set to fall within a predetermined range including the linear expansion coefficient of the laser diode array (6).

*FIG.1*

## Description

Technical Field

The present invention relates to a laser module using a laser diode array device.

Background Art

Recently, there has been an increasing need of a higher output of a laser diode (LD) used for processing or as a light source. As a technique of increasing an output of the LD, there is a method using a laser diode array device (hereinafter, referred to as the LD array) in which a plurality of light-emitting spots (emitters) are arrayed in a parallel arrangement within a single chip.

The LD array is substantially equivalent to dispose a plurality of devices each having one light-emitting spot in a parallel arrangement. Accordingly, both a device size and a gross heating value increase with an increasing number of emitters disposed in a parallel arrangement. As the device size increases, stress intensification occurs when the LD array is mounted or driven due to a mismatch of linear expansion coefficients between the device and a joined member.

Then, there occurs a phenomenon (Dark Line Defect abbreviated by DLD) in which an output decreases as a defect generated and grown in the device reaches an active layer, or a phenomenon in which the device breaks up as cracking or the like develops. Also, when a device temperature is high, development of the defect is accelerated and consequently a device life is shortened. Given these circumstances, there is a need for a module structure capable of driving the LD array with low stress at suitable temperatures.

As a method of solving such a problem, there is proposed a structure formed by interposing, as a sub-mount, a plate member made of CuW having a linear expansion coefficient close to that of the LD and relatively high heat conductivity between the LD array and a cooling structure member (Patent Document 1 and Patent Document 2).

Related Art Documents

Patent Documents

Patent Document 1: JP-A-2008-172 141
Patent Document 2: JP-A-2006-344 743

Disclosure of the Invention

Problems to be Solved by the Invention

However, CuW is expensive in comparison with general conductive materials, such as Cu. Hence, in a case where a component made of CuW is used, there is a problem that the manufacturing costs are increased.

The invention therefore has an object to provide an inexpensive laser module by lowering stress acting on an LD array without using an expensive material, such as CuW.

Means for Solving the Problems

A laser module of the invention includes: a heat sink that releases heat from a member in contact with the heat sink; a sub-mount substrate that is disposed on the heat sink and made of an insulating material; a feeding layer that is disposed on the sub-mount substrate; and a laser diode array that has a plurality of light-emitting portions disposed on the feeding layer in a parallel arrangement.

A linear expansion coefficient of the laser diode array is larger than a linear expansion coefficient of the sub-mount substrate and smaller than linear expansion coefficients of the feeding layer and the heat sink. The linear expansion coefficient of the sub-mount substrate in a state connected to the heat sink is set to fall within a predetermined range including the linear expansion coefficient of the laser diode array.

Also, another embodiment of a laser module of the invention includes: a heat sink that releases heat from a member in contact with the heat sink; a sub-mount substrate that is disposed on the heat sink and made of an insulating material a feeding layer that is disposed on the sub-mount substrate; and a laser diode array that has a plurality of light-emitting portions disposed on the feeding layer in a parallel arrangement.

A linear expansion coefficient of the laser diode array is larger than a linear expansion coefficient of the sub-mount substrate and smaller than linear expansion coefficients of the feeding layer and the heat sink. A joint width between the heat sink and the sub-mount substrate is set to a range from a width of the laser diode array at a lower limit to an extent to which a relation between stress acting on the laser diode array and the joint width is linearly approximated at an upper limit.

Also, still another embodiment of a laser module of the invention includes: a heat sink that releases heat from a member in contact with the heat sink; a sub-mount substrate that is disposed on the heat sink and made of an insulating material; a feeding layer that is disposed on the sub-mount substrate; and a laser diode array that has a plurality of light-emitting portions disposed on the feeding layer in a parallel arrangement.

A material of the sub-mount substrate is AIN or SiC.

A material of the heat sink is Cu. A material of the laser diode array is GaAs. A material of the feeding layer is Cu. Let B be a width dimension of the laser diode array, then a joint width dimension A of the sub-mount substrate with respect to the heat sink satisfies a relation expressed as: $B \le A \le B + 4$ mm.

Advantages of the Invention

According to the invention, it becomes possible to obtain an inexpensive laser module by lowering stress applied to the LD array.

Brief Description of the Drawings

FIG. 1     is a perspective view showing an overall configuration of a laser module according to a first embodiment of the invention.

FIG. 2     is a front view showing a configuration of the laser module according to the first embodiment of the invention.

FIG. 3     is a side view showing the configuration of the laser module according to the first embodiment.

FIG. 4     is a view schematically showing deformation behaviors of a heat sink, a sub-mount substrate, plated layers, and an LD array in the course of cooling after the respective elements of the laser module are soldered.

FIG. 5     is a graph showing relations between a joint width A between the sub-mount substrate and the heat sink and stress acting in a width direction of the LD array in respective cases where the LD array has different widths in the laser module according to the first embodiment of the invention.

FIG. 6     is a graph showing relations between the joint width A between the sub-mount substrate and the heat sink and stress acting in a width direction of the LD array in respective cases where the sub-amount substrate has different thicknesses in the laser module according to the first embodiment of the invention.

FIG. 7     is a view showing a circuit diagram of the LD array and the plated layer according to the first embodiment of the invention.

FIG. 8     is a graph showing a relation between an emitter arrangement and an applied current in the LD array of the laser module according to the first embodiment of the invention.

FIG. 9     is a graph showing a relation between a conductor thickness dimension of the plated layer and a current variation among respective emitters and a relation between the conductor thickness dimension of the plated layer and a plated surface roughness in the laser module according to the first embodiment of the invention.

Best Mode for Carrying Out the Invention

First Embodiment

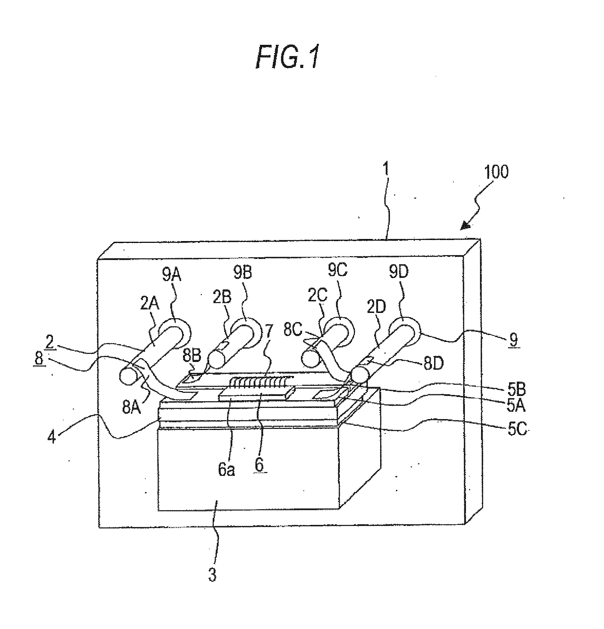

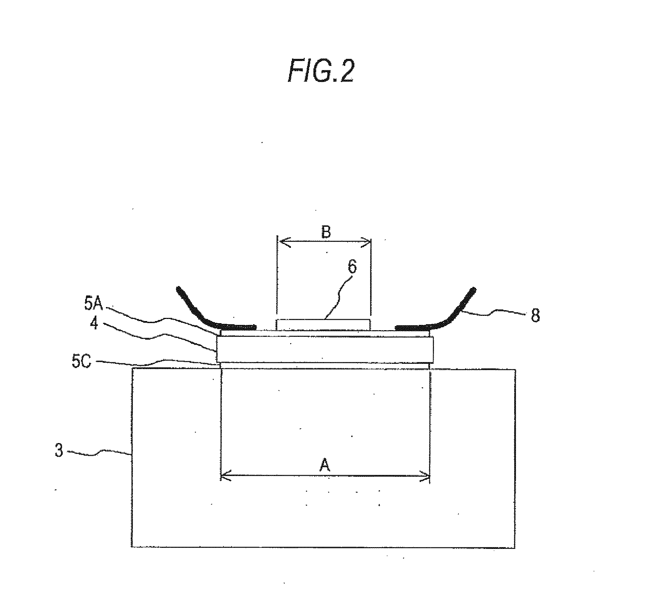

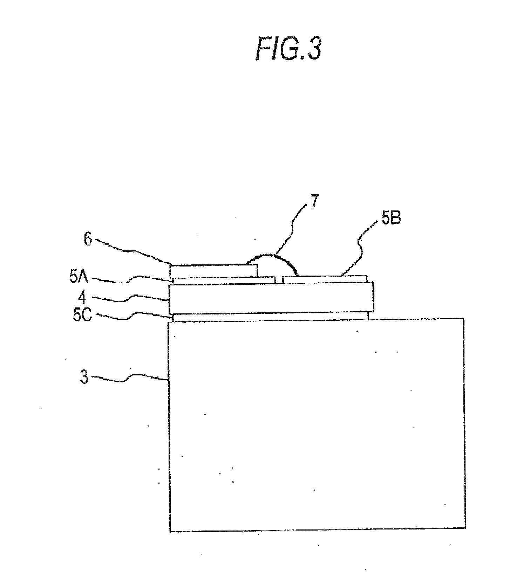

Hereinafter, a structure of a laser module 100 according to this embodiment of the invention will be described using FIG. 1 through FIG. 3. FIG. 1 is a perspective view of the laser module 100 of this embodiment. FIG. 2 is a front view of the laser module 100 of this embodiment. FIG. 3 is a side view of the laser module 100 of this embodiment. Herein, a side of the laser module 100 from which a laser beam is emitted is defined as the front surface.

The laser module 100 is formed of a stem 1, a lead pin 2, a heat sink 3, a sub-mount substrate 4 having plated layers 5A, 5B, and 5C, an LD array 6, a wire interconnection 7, and a ribbon interconnection 8.

A stem 1 is a plate-like member made of a metal material, such as Fe, and provided with four openings through which lead pins 2A through 2D are inserted.

The lead pins 2A through 2D are made of a conductive material and serve as feeding wires that supply the LD array 6 with power from a non-illustrated power supply. Sealing portions 9A through 9D formed of an insulating member, such as glass, are formed between the respective lead pins 2A through 2D and the stem 1. The lead pins 2A through 2D are electrically isolated from the stem 1 by the sealing portions 9A through 9D, respectively. In this manner, the lead pins 2A through 2D penetrating through the stem 1 are electrically isolated and fixed in this state by glass sealing.

The heat sink 3 is made of a highly heat-conductive metal material, such as Cu and Fe. The heat sink 3 is a heat-releasing member that releases heat from a member in contact with the heat sink 3, and joined to the stem 1 by soldering or silver soldering. Alternatively, the heat sink 3 is a structure formed integrally with the stem 1 by cold forging or the like.

The sub-mount substrate 4 is an insulating substrate made of a highly heat-conductive insulating material, such as AlN and SiC, and disposed between the heat sink 3 and the LD array 6. The plated layers 5A, 5B, and 5C made of a highly electrically-conductive and heat-conductive and low-rigid metal material, such as Cu, are formed on a bottom surface on the side of the heat sink 3 and a top surface on the side of the LD array 6. The sub-mount substrate 4 is fixedly mounted on the heat sink 3 by soldering or the like via the plated layer 5C. In a case where the sub-mount substrate 4 is fixedly mounted on the heat sink 3 by soldering, AuSn solder can be used as a joint material.

The LD array 6 is a semiconductor device formed of a plurality of interconnected emitters (light-emitting portions) in a parallel arrangement. The LD array 6 has electrodes on a bottom surface and a top surface on a side of the sub-mount substrate 4 and emits a laser beam from a front portion 6a when a current is applied between the two electrodes. The bottom surface of the LD array 6 is joined to the plated layer 5A on the sub-mount substrate 4 by soldering or the like.

Accordingly, the electrode in the bottom surface of the LD array 6 and the plated layer 5A are electrically connected to each other. In a case where the LD array 6 and the plated layer 5A are joined by soldering, AuSn solder can be used as a joint material. The electrode in the top surface of the LD array 6 is electrically connected to the plated layer 5B on the sub-mount substrate 4 with the wire interconnection 7 formed of a plurality of fine metal wires.

Both end portions of the top surface of the plated layer 5A serving as a feeding layer that supplies the LD array 6 with power are electrically joined to the lead pins 2A and 2D by ribbon interconnections 8A and 8D, respectively. Both end portions of the top surface of the plated layer 5B serving as a feeding layer that supplies the LD array 6 with power are electrically joined to the lead pins 2B and 2C by ribbon interconnections 8B and 8C, respectively.

In FIG. 1, the LD array 6 is mounted with an anode located at the bottom, that is, in a junction-down state. Hence, when the lead pins 2A through 2D are connected to a non-illustrated power supply, a current flows through a feeding path starting from the lead pins 2A and 2D → the ribbon interconnections 8A and 8D → the plated layer 5A → the LD array 6 → the wire interconnection 7 → the plated layer 5B → the ribbon interconnections 8B and 8C → the lead pins 2B and 2C.

By allowing a current to flow through the LD array 6, a current flows to the respective interconnected emitters placed in a parallel arrangement inside the LD array 6. Hence, a laser beam is emitted from the front portion 6a as the respective emitters oscillate and emit light.

Stress acting on the LD array 6 will now be described. Hereinafter, assume that the LD array 6 and the plated layer 5A as well as the heat sink 3 and the plated layer 5C are joined by soldering using AuSn solder preliminarily vapor deposited on the plated layer 5A and the plated layer 5C.

These members are joined in the following order. That is, the sub-mount substrate 4 is placed on the heat sink 3 first in such a manner that the plated layer 5C comes into contact with the heat sink 3. Further, the LD array 6 is disposed on the plated layer 5A. Thereafter, these components are heated to 300 °C to 400 °C to melt AuSn solder followed by cooling to allow the AuSn solder to solidify. The heat sink 3 and the sub-mount substrate 4 as well as the sub-mount substrate 4 and the LD array 6 are joined by joining the heat sink 3 and the plated layer 5C as well as the LD array 6 and the plated layer 5A in this manner.

Temperatures of the components to be joined are substantially the same during the heating and cooling processes as above. However, for example, assume that the LD array 6 is made of GaAs, the sub-mount substrate 4 is made of SiC or AlN, and the plated layer 5C and the heat sink 3 are made of Cu. Then, a linear expansion coefficient $\alpha$ of GaAs is 6.6 x 10$^{-6}$ [mm/(nm·K)], a linear expansion coefficient of the sub-mount substrate 4 is 4.8 $\times$ 10$^{-6}$ [mm/(mm·K)] in the case of AlN and 3.7 x 10$^{-5}$ [mm/(mm·K)] in the case of SiC, and a linear expansion coefficient p of Cu is 16.7 x 10$^{-6}$ [mm/(mm·K)].

Hence, during a heating process to melt AuSn solder, heat expansion corresponding to the linear expansion coefficients of the respective materials occurs in the LD array 6, the sub-mount substrate 4, the plated layer 5C, and the heat sink 3 as their temperatures rise. Also, during a cooling process to solidify AuSn solder, heat contraction corresponding to the linear expansion coefficients of the respective materials occurs in the LD array 6, the sub-mount substrate 4, the plated layer 5C, and the heat sink 3 as their temperatures drop.

In the case of AuSn solder (eutectic), the LD array 6 and the sub-mount substrate 4 are joined as the solder solidifies in the course of cooling when the LD array 6 and the sub-mount substrate 4 are cooled to 280 °C, which is a melting point of the AuSn solder. However, as the LD array 6 and the sub-mount substrate 4 in a jointed state are cooled further from the melting point to room temperature, stress corresponding to a difference of amounts of heat contraction between the sub-mount substrate 3 and the LD array 6 acts on the LD array 6. Stress applied to the LD array 6 becomes higher as a difference of amounts of heat contraction between the sub-mount substrate 3 and the LD array 6 becomes larger. As stress applied to the LD array 6 becomes higher, DLD described above occurs or cracking or the like develops. Consequently, a drive life of the LD array 6 is shortened.

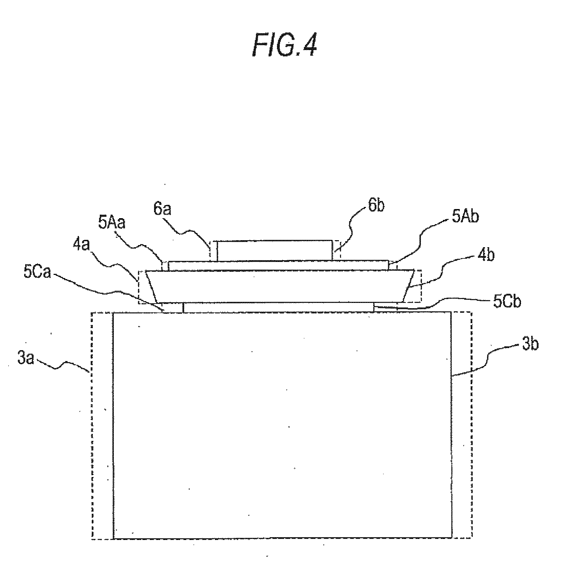

FIG. 4 is a view schematically showing expansion and contraction of the heat sink 3, the sub-mount substrate 4, the plated layers 5A and 5C, and the LD array 6 caused by a temperature change in the course of heating and cooling. In FIG. 4, shapes of a heat sink 3a, a sub-mount substrate 4a, plated layers 5Aa and 5Ca, and an LD array 6a during heating are indicated by a broken line, and shapes of a heat sink 3b, a sub-mount substrate 4b, plated layers 5Ab and 5Cb, and an LD array 6b after cooling are indicated by a solid line. Hereinafter, let A be a joint width dimension between the sub-mount substrate 4 and the heat sink 3 and B be a joint width dimension B between the sub-mount substrate 4 and the LD array 6.

As is shown in FIG. 4, the respective layers expand or contract in response to a temperature change. However, because both of the heat sink 3 and the plated layer 5C are made of Cu, there is no difference of amounts of contraction. Hence, regarding stress between the sub-mount substrate 4 and the plated layer 5C, contraction of the plated layer 5C can be identified with contraction of the heat sink 3.

Also, regarding contraction of the plated layer 5A, for example, when a thickness of the sub-mount substrate 4 is about 300 $\mu$m and a thickness of the plated layer 5A is 100 $\mu$m or less, then given that Cu has a Young's modulus of 130 GPa, which is one third or less the Young's modulus of SiC, 440 GPa (that of AlN is 320 GPa), Cu has a lower rigidity than SiC. Hence, influences of the plated layer 5A on stress acting on the LD array 6 become smaller. Accordingly, the plated layer 5A is negligible in terms of stress between the LD array 6 and the sub-mount substrate 4.

At a time point when the temperature of AuSn solder drops to the melting point in the course of cooling and AuSn solder solidifies, heat expansion is occurring in the respective components. However, because the solder is in a molten state until immediately before, neither component receives stress from the adjacent component.

However, when the components are cooled further and the temperatures drop by $\Delta T$ from the solder melting point, at the joint portion between the heat sink 3 and the sub-mount substrate 4, the heat sink 3 made of Cu starts to contract by a length $\rho A\Delta T$ while the sub-mount substrate 4 made of AlN or SiC starts to contract by $\beta A\Delta T$. Although the heat sink 3 and the sub-mount substrate 4 are joined to and constrained by each other, because p > P and a thickness of the heat sink 3 is sufficiently larger than a thickness of the sub-mount substrate 4, the sub-mount substrate 4 receives stress from the heat sink 3 in a direction in which the width is shortened on the surface joined to the heat sink 3. Accordingly, the sub-mount substrate 4 undergoes contraction deformation considerably in comparison with a case where the sub-mount substrate 4 merely contracts alone.

C3n the other hand, a thickness of the LD array 6 is generally about 100 $\mu$m and a Young's modulus of GaAs as a chief material is as small as 83 GPa in comparison with the Yong's modulus of the sub-mount substrate 4. Hence, the sub-mount substrate 4 hardly receives influences of heat contraction from the LD array 6 on the surface joined to the LD array 6. Hence, the sub-mount substrate 4 undergoes maximum contraction deformation due to influences of heat contraction of the heat sink 3 on the surface joined to the heat sink 3.

However, because the sub-mount substrate 4 hardly receives influences of heat contraction on the surface joined to the LD array 6, influences of heat contraction of the heat sink 3 are eased more with increasing proximity to the surface joined to the LD array 6. Eventually, an amount of contraction becomes a minimum on the surface joined to the LD array 6.

Let $\Delta X$ be an amount of contraction of the sub-mount substrate 4 on the surface joined to the LD array 6. Then, an amount of contraction, $\Delta X$, is smaller than an amount of contraction of the heat sink 3 alone and larger than an amount of contraction of the sub-mount substrate 4 alone. Hence, the amount of contraction, $\Delta X$, satisfies a relation expressed as:

$$\beta B\Delta T < \Delta X < \rho B\Delta T.$$

Also, because $\beta < \alpha < p$ is given, an amount of contraction of the LD array 6 alone, $\alpha B\Delta T$, satisfies a relation expressed as: $\beta B\Delta T < \alpha B\Delta T < \rho B\Delta T$, Herein, as an amount of contraction, $\Delta X$, becomes closer to an amount of contraction of the LD array, $\alpha B\Delta T$, stress applied to the LD array 6 is eased more due to a difference of heat expansions between the LD array 6 and other components, such as the sub-mount substrate 4.

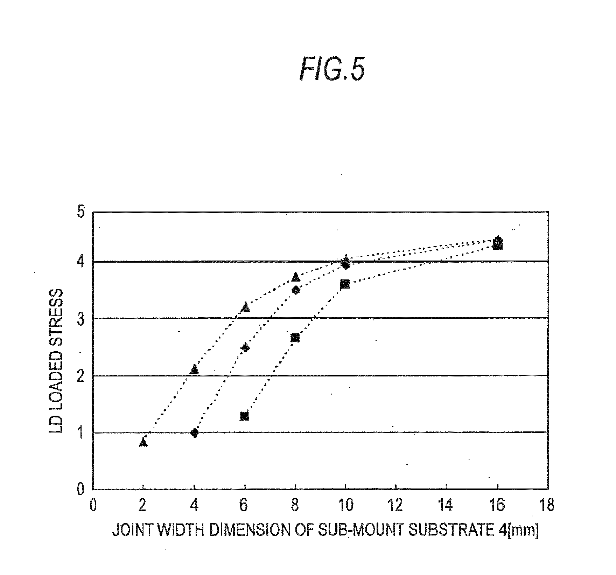

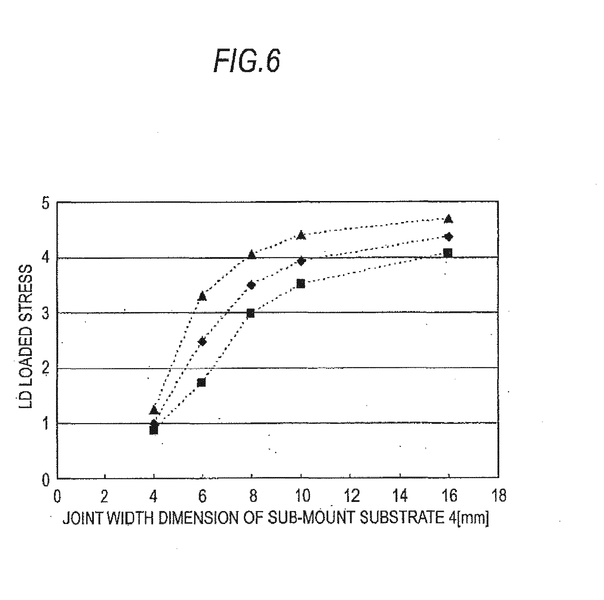

Figs. 5 and 6 are graphs showing calculation results on a relation between the joint width dimension A of the sub-mount substrate 4 and an average value of stress loaded on the LD array 6 (LD loaded stress) in the laser module according to the first embodiment of the invention. FIG. 5 shows cases where a thickness of the sub-mount substrate 4 is 300 $\mu$m and widths of the LD array 6 are 2 mm, 4 mm, and 6 mm.

In FIG. 5, data in the case where a width of the LD array 6 is 2 mm is indicated by triangles, data in the case where a width of the LD array 6 is 4 mm is indicated by diamonds, and data in the case where a width of the LD array 6 is 6 mm is indicated by squares. Also, FIG. 6 shows cases where a width of the LD array 6 is 4 mm and thicknesses of the sub-mount substrate 4 are 200 $\mu$m, 300 $\mu$m, and 400 $\mu$m.

In FIG. 6, data in the case where a thickness of the sub-mount substrate 4 is 200 $\mu$m is indicated by triangles, data in the case where a thickness of the sub-mount substrate 4 is 300 $\mu$m is indicated by diamonds, and data in the case where a thickness of the sub-mount substrate 4 is 400 $\mu$m is indicated by squares. Herein, a value of LD loaded stress is normalized on the basis of the LD loaded stress set to 1 when a width of the LD array 6 is 4 mm, a thickness of the sub-mount substrate 4 is 300 $\mu$m, and a width of the sub-mount substrate 4 is 4 mm.

Let A be a joint width dimension of the sub-mount substrate 4 and B be a width dimension of the LD array 6, then stress loaded on the LD array becomes a minimum when substantially A = B independently of a width of the LD array 6 and a thickness of the sub-mount substrate 4, then rises abruptly in a range, $B \leq A \leq B + 4$ mm, and rises moderately thereafter.

Herein, both of an amount of contraction of the LD array 6 and an amount of contraction of the sub-mount substrate 4 have a distribution that takes 0 at a center in a width direction and reaches a maximum at end portions in the width direction.

Stress loaded on the LD array 6 depends on a difference between an amount of contraction of the sub-mount substrate 4 and an amount of contraction of the LD array 6. Accordingly, the stress has a distribution that takes 0 at a center of the LD array 6 in a width direction and reaches a maximum at end portions of the LD array 6 in the width direction.

Hence, when an amount of contraction of the LD array 6 and an amount of contraction of the sub-mount substrate 4 can be made close values at the end portions of the LD array 6 in the width direction where stress loaded on the LD array 6 reaches a maximum, it becomes possible to reduce stress loaded on the LD array 6 and a reliability of the LD array 6 can be ensured.

In order to make an amount of contraction of the LD array 6 and an amount of contraction of the sub-mount substrate 4 close values at the end portions of the LD array 6 in the width direction, a value of A - B, which is an amount of protrusion of the joint width A of the sub-mount substrate 4 from the LD array 6, becomes more dominant than the width dimension B of the LD array 6. Hence, it is merely necessary to determine a dimension of A of the sub-mount substrate on the basis of the width dimension B of the LD array 6 so that a value of A - B is equal to or less than a predetermined value.

Also, a wavelength of a laser beam output from the LD array 6 differs with stress loaded on the LD array 6. Hence, by determining the joint width A of the sub-mount substrate 4 in a range within which stress loaded on the LD array 6 varies linearly with the joint width A of the sub-mount substrate 4, it becomes possible to achieve an advantage that not only can stress loaded on the LD array 6 be reduced, but also a wavelength of a laser beam can be adjusted to a desired wavelength.

Accordingly, it is merely necessary to select the joint width A of the sub-mount substrate 4 to fall within a range, $B \leq A \leq B + 4$ mm, more specifically, a range from the width dimension of the LD array at the lower limit to an extent to which stress loaded on the LD array 6 can be linearly approximated with the joint width A of the sub-mount substrate 4 at the upper limit.

The linear expansion coefficient $\beta$ of the sub-mount substrate 4 is smaller than the linear expansion coefficient $\alpha$ of the LD array 6. Hence, in a case where the heat sink 3 is not taken into consideration in the course of cooling, an amount of contraction of the sub-mount substrate 4 becomes smaller than an amount of contraction of the LD array 6 and the LD array 6 receives stress such that extends a width length on the surface joined to the sub-mount substrate 4.

In this embodiment, however, because the sub-mount substrate 4 is disposed on the heat sink 3 having a larger linear expansion coefficient than the sub-mount substrate 4 and the sub-mount substrate 4 receives compression from the heat sink 3 in the course of cooling.

Accordingly, it is merely necessary to adjust linear expansion coefficients of the respective components and the joint width between the sub-mount substrate 4 and the heat sink 3, so that a difference between an amount of contraction of the sub-mount substrate 4 on a boundary to the LD array 6 and an amount of contraction of the LD array 6 on a boundary to the sub-mount substrate 4 upon reception of stress in a contraction direction from the heat sink 3 falls within a predetermined range.

Hence, by setting "a deemed linear expansion coefficient of the sub-mount substrate 4", which is a linear expansion coefficient of the sub-mount substrate 4 in a state joined to the heat sink 3, to substantially in the same range of the linear expansion coefficient of the LD array 6, more specifically, by setting "a deemed linear expansion coefficient of the sub-mount substrate 4" to fall within a predetermined range including the linear expansion coefficient of the LD array 6, it becomes possible to reduce stress generated in the LD array 6.

Herein, "a deemed linear expansion coefficient of the sub-mount substrate 4", which is a linear expansion coefficient of the sub-mount substrate 4 in a state connected to the heat sink 3, can be obtained by finding an amount of deformation of the sub-mount substrate 4 in a state joined to the heat sink 3 by a structural analysis.

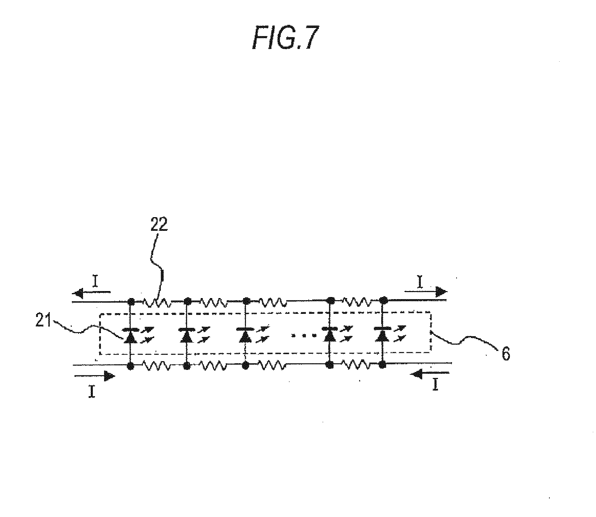

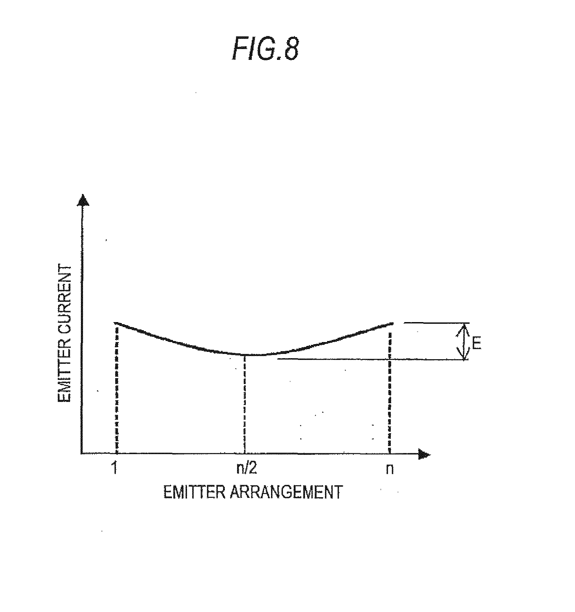

A variation of a current in the LD array 6 of the laser module according to the first embodiment of the invention will now be described using FIG. 7 and FIG. 8. FIG. 7 is a view showing a circuit configuration of the LD array 6 and the plated layers 5A and 5B. FIG. 8 is a graph showing a relation between an emitter arrangement and an applied current of the LD array 6 in the laser module according to the first embodiment of the invention. Hereinafter, a difference E between a maximum and a minimum of the emitter current shown in FIG. 8 is referred to as a current variation.

When a current is flown through the laser light source module 100, power is supplied to the respective emitters 21 from the both side surfaces of the LD array 6 by way of the ribbon interconnection 8. The ribbon interconnections 8A and 8D are connected to the both end portions of the plated layer 5A while the respective emitters are disposed in a parallel arrangement at regular intervals in the LD array 6 between the portions to which the ribbon interconnections 8A and 8D are connected.

Hence, as is shown in FIG. 7, conductor resistances 22 are present between every emitter 21 and the adjacent emitter 21. Because of influences of the conductor resistances 22, a current flows readily to the emitters 21 located (on the outer side of the LD array 6) closer to the portions to which the ribbon intersections 8A and 8D are connected whereas a current hardly flours to the emitters 21 located (on the inner side of the LD array 6) remote from the portions to which the ribbon intersections 8A and 8D are connected.

Hence, in a laser module in the related art, a current flowing to the respective emitters 21 and intensity of light output according to the current vary and a current flows excessively to the emitters 21 on the outer side. Reliability over a long term is thus deteriorated.

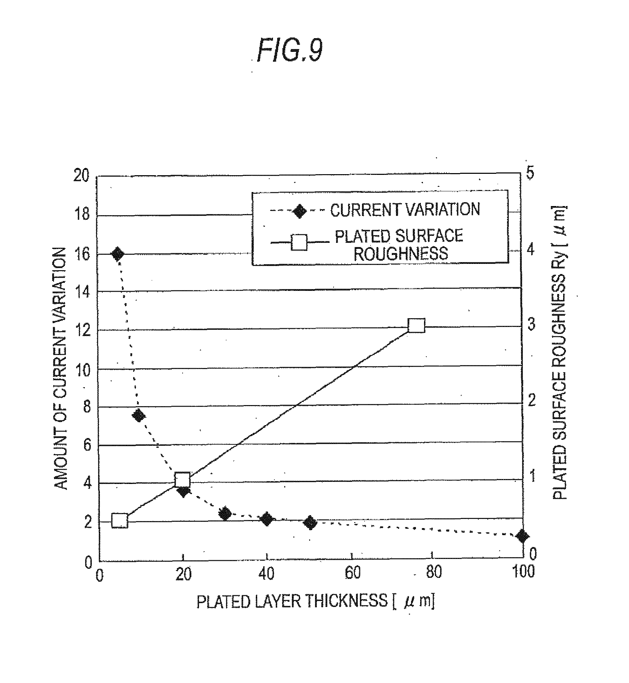

In contrast, the laser module of this embodiment overcomes this inconvenience by adjusting a layer thickness of the plated layers 5A and 5B. FIG. 9 is a graph showing a correlation between a current variation and a thickness of the plated layers 5A and 5B and a correlation between a conductor thickness dimension of the plated layer 5A and a surface roughness of the plated layer 5A in a case where 15 emitters are disposed at a pitch of 200 $\mu$m in the LD array of the laser module according to the first embodiment of the invention.

A value of a current variation of FIG. 9 is normalized on the basis of the current variation set to When the thickness of the plated layers 5A and 5B is 100 $\mu$m. It is un-

derstood from FIG. 9 that because a current variation increases abruptly when the thickness of the plated layers 5A and 5B becomes 30 μm or less, a current variation can be suppressed to a low level by setting the thickness of the plated layers 5A and 5B to 30 μm or above. The reason for this is as follows.

That is, because an increase in thickness of the plated layers 5A and 5B corresponds to an increase in thickness of wires electrically interconnecting the emitters 21, the conductor resistances 22 among the respective emitters 21 becomes smaller as a thickness of the plated layers 5A and 5B increases. Hence, a current variation, which is a difference between a current flowing to the emitters 21 placed on the outer side and a current flowing to the emitters 21 placed on the inner side, becomes smaller. On the other hand, when the thickness of the plated layers 5A and 5B is 100 μm or above, influences of the plated layer 5A on stress loaded on the LD array 6 becomes significant and the discussion by disregarding the plated layers become inappropriate. Accordingly, the thickness C of the plated layers 5A and 5B on the sub-mount substrate 4 is preferably set to satisfy a relation expressed as: 30 [μm] ≤ C ≤ 100 [μm].

Also, as is shown in FIG. 9, because a current variation can be suppressed to a practical level by setting the thickness of the plated layers 5A and 5B to 10 μm or above, it is merely necessary to set at least the thickness C of the plated layers 5A and 5B to satisfy a relation expressed as: 10 [μm] ≤ C ≤ 100 [μm]. In this manner, by maintaining the layer thickness of the plated layers 5A and 5B to or above a thickness at or above which a current variation hardly occurs, the conductor resistances 22 among the respective emitters can be reduced. It thus becomes possible to obtain a light output without a variation.

Also, because plating is a process in which crystals are grown in a thickness direction from the substrate surface, there is a variation in degree of in-plane growth. Formally, in-plane variation is suppressed by an additive or the like. Even in that case, however, a surface roughness of the plated surface increases as a plating thickness increases.

It is understood from FIG. 9 that a surface roughness Ry (a difference between a thinnest portion and a thickest portion) of the plated layer 5A is about 1 μm when a thickness of the plated layer 5A is 20 μm and about 3 μm when a thickness of the plated layer 5A is 75 μm. When stress is intensively loaded on the LD array 6 in convex portions on the surface of the plated layer 5A due to loading at the time of mounting, it is known that a defect occurs to deteriorate reliability and stress causes a variation in optical property that deteriorates a laser performance, such as a polarization property.

Because it is general that a thickness of a solder layer between the LD array 6 and the sub-mount substrate 4 is about 2 μm to 3 μm after the LD mounting, it is preferable to set the surface roughness of the plated layer 5A to about 2 μm or less. It is understood from FIG. 9 that the surface roughness Ry of the plated layer 5A on which to mount the LD array 6 can be suppressed to 2 μm or less by setting the thickness C of the plated layer 5A to a range of 10 μm to 50 μm both inclusive.

It thus becomes possible to form a laser module in which a current variation of the LD array 6 is reduced without impairing the polarization property and the reliability. It should be appreciated, however, that the above does not apply to a case where surface roughness is reduced after the plating by processing, such as polishing, although the manufacturing costs of the laser module 100 are increased.

Also, Cu having a Young's modulus as small as 130 GPa, which is about half the Young's modulus of CuW, 255 GPa, has low rigidity. Hence, by increasing the layer thickness of the plated layer 5A to 30 μm or above, even in a case where a load is generated in the LD array 6 due to loading during heat expansion or joining, the plated layer 5A serves as an interference layer and stress can be reduced.

As has been described, the laser module according to the first embodiment of the invention is configured in such a manner that a difference between an amount of heat expansion of the surfaces of composite materials including the heat sink 3, the sub-mount substrate 4, and the plated layers 5A and 5C joined to the LD array 6 and an amount of heat expansion of the LD array 6 falls within a predetermined range by adjusting the joint width dimension A between the heat sink 3 and the sub-mount substrate 4, that is, in such a manner that a deemed linear expansion coefficient of the sub-mount substrate 4 in a state connected to the heat sink 3 falls within a predetermined range including the linear expansion coefficient of the LD array 6.

It thus becomes possible to obtain an inexpensive laser module with good heat conductivity by reducing stress loaded on the LD array 6 when the LD array 6 is joined by soldering and the LD array 6 is driven.

Also, by providing the plated layers 5A and 5I3 each having a thickness of 30 μm or above on the sub-mount substrate 4 to serve as a feeding conductor, it becomes possible to lessen a voltage drop among the respective emitters 21 in the LD array 6 on the feeding conductor even in a case where a large current is supplied.

Consequently, a current flows to the respective emitters 21 in the LD array 6 in an equal amount and a current is prevented from flowing concentrically to a part of the emitters 21. Hence, neither excessive light emission nor a temperature change occurs and a long life property can be enhanced.

Also, CuW having a volume resistivity of 5.4 [μΩ·cm] is used as a material of the sub-mount substrate 4 in the related art, whereas Cu having a volume resistivity of 1.7 [μΩ·cm], which is about one third the volume resistivity of CuW, is used herein for the feeding layer. It thus becomes possible to suppress an applied current variation among the respective emitters 21 caused by conductor resistances to one third in the same structure.

Hence, in comparison with a case where CuW is used as a material of the surmount substrate 4 as a stress easing structure and the feeding conductor in the related art, it becomes possible to prolong a life by suppressing concentration of a current to the emitters 21 on the outer side.

Also, when the LD array 6 oscillates and emits light, power that does not contribute to light emission is consumed as heat. However, an internal defect of the LD array 6 develops further as the temperature thereof rises higher and the life thereof is shortened. By thermally coupling the stem 1 to a cooling device, heat generated in the LD array 6 is transferred to the outside of the laser module 100 by way of a route: the sub-mount substrate 4 → the heat sink 3 → the stem 1.

Accordingly, a thermal resistance value of the heat transfer route is considerably concerned with a temperature of the LD array 6. In the laser module of the first embodiment, Cu having heat conductivity as high as 398 [Wm·K], which is about 2.3 times higher than the heat conductivity of CuW, 170 [Wm·K], is used instead of CuW.

Hence, in comparison with the case of using CuW, thermal resistance of the conductor portion is reduced to half or less the thermal resistance in the case of using CuW. It thus becomes possible to set a temperature of the LD array 6 in a low suitable temperature range. Hence, a life of the LD array 6 can be prolonged.

In the structure of the first embodiment, the feeding layer is formed on the sub-mount substrate 4 integrally by plating. Hence, in comparison with a case where a CuW substrate is mounted on the sub-mount substrate 4, the number of components can be reduced and the component assembling costs can therefore be saved. The feeding layer is not necessarily formed by plating and it may be configured in such a manner that a plate member is soldered using AuSn solder.

In this case, a surface roughness of the plate member on which to mount the LD array 6 does not depend on a thickness of the plate member. Hence, it is not necessary to give considerations to deterioration of the laser property and the reliability caused when a thickness of the plate member is increased.

In the first embodiment, the plated layers 5A and 5B are formed on the top surface of the sub-mount substrate 4 and the plated layer 5C is formed on the bottom surface. It should be appreciated, however, that the plated layer 5C on the bottom surface is not necessarily provided.

The above has described a case where the LD array 6 is mounted in a junction-down direction. It should be appreciated, however, that even in a case where the LD array 6 is mounted in a junction-up direction, only a current flows in an opposite direction and no influences are given to the configuration and the advantage.

Description of Preference Numerals and Signs

| 100: | laser light module |
|------|------|
| 1: | stem |
| 2: | lead pin |
| 3: | heat sink |
| 4: | sub-mount substrate |
| 5A, 5B, 5C: | plated layer |
| 6: | LD array |
| 7: | wire interconnection |
| 8: | ribbon interconnection |
| 21: | emitter |
| 22: | conductor resistance |

**Claims**

1. A laser module, comprising:

   - a heat sink that releases heat from a member in contact with the heat sink;
   - a sub-mount substrate that is disposed on the heat sink and made of an insulating material;
   - a feeding layer that is disposed on the sub-mount substrate; and
   - a laser diode array that has a plurality of light-emitting portions disposed on the feeding layer in a parallel arrangement,
   wherein:
   - the linear expansion coefficient of the laser diode array is larger than a linear expansion coefficient of the sub-mount substrate and smaller than linear expansion coefficients of the feeding layer and the heat sink; and
   - the linear expansion coefficient of the sub-mount substrate in a state connected to the heat sink is set to fall within a predetermined range including the linear expansion coefficient of the laser diode array.

2. A laser module, comprising:

   - a heat sink that releases heat from a member in contact with the heat sink;
   - a sub-mount substrate that is disposed on the heat sink and made of an insulating material;
   - a feeding layer that is disposed on the sub-mount substrate; and
   - a laser diode array that has a plurality of light-emitting portions disposed on the feeding layer in a parallel arrangement,
   wherein:
   - the linear expansion coefficient of the laser diode array is larger than a linear expansion coefficient of the sub-mount substrate and smaller than linear expansion coefficients of the feeding layer and the heat sink; and
- a joint width between the heat sink and the sub-mount substrate is set to a range from a width of the laser diode array at a lower limit to an extent to which a relation between stress acting on the laser diode array and the joint width is linearly approximated at an upper limit.

3. A laser module, **characterized by** comprising:

   - a heat sink that releases heat from a member in contact with the heat sink;
   - a sub-mount substrate that is disposed on the heat sink and made of an insulating material;
   - a feeding layer that is disposed on the sub-mount substrate; and
   - a laser diode array that has a plurality of light-emitting portions disposed on the feeding layer in a parallel arrangement, and
   **characterized in that**:
   - the material of the sub-mount substrate is AlN or SiC;
   - the material of the heat sink is Cu;
   - the material of the laser diode array is GaAs;
   - the material of the feeding layer is Cu; and
   - let B be a width dimension of the laser diode array, then a joint width dimension A of the sub-mount substrate with respect to the heat sink satisfies a relation expressed as:

   $$B \leq A \leq B + 4 \text{ mm}.$$

4. The laser module according to any one of claims 1 through 3, **characterized in that**:

   - the material of the sub-mount substrate is AlN or SiC;
   - the material of the heat sink is Cu;
   - the material of the laser diode array is GaAs;
   - the material of the feeding layer is Cu; and
   - the thickness of the feeding layer is in a range of 10 $\mu$m to 100 $\mu$m both inclusive.

5. The laser module according to any one of claims 1 through 3, **characterized in that**:

   - the material of the sub-mount substrate is AlN or SiC;
   - the material of the heat sink is Cu;
   - the material of the laser diode array is GaAs;
   - the material of the feeding layer is Cu; and
   - the thickness of the feeding layer is in a range of 30 $\mu$m to 100 $\mu$m both inclusive.

6. The laser module according to any one of claims 1 through 3, **characterized in that**:

- the material of the sub-mount substrate is AlN or SiC;
- the material of the heat sink is Cu;
- the material of the laser diode array is GaAs;
- the material of the feeding layer is Cu; and
- the thickness of the feeding layer is in a range of 10 $\mu$m to 50 $\mu$m both inclusive.

# FIG.1

## FIG.2

FIG.3

## FIG.4

## FIG.5

## FIG.6

FIG.7

FIG.8

# FIG.9

## INTERNATIONAL SEARCH REPORT

| | International application No. |
|---|---|
| | PCT/JP2010/007301 |

A. CLASSIFICATION OF SUBJECT MATTER
*H01S5/022*(2006.01)i

According to International Patent Classification (IPC) or to both national classification and IPC

B. FIELDS SEARCHED

Minimum documentation searched (classification system followed by classification symbols)
G02B6/26, 6/30-6/34, 6/42, H01L21/18-21/20, 21/34-21/36, 21/84, 31/00-31/0264, 31/08-31/09, 33/00-33/64, H01S5/00-5/50

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2002-299744 A  (Sony Corp.),<br>11 October 2002 (11.10.2002),<br>paragraphs [0009] to [0027]; fig. 1, 3<br>(Family: none) | 1-6 |
| Y | JP 5-226764 A  (NEC Corp.),<br>03 September 1993 (03.09.1993),<br>paragraphs [0002] to [0010]; fig. 2<br>(Family: none) | 2-6 |
| Y | JP 2009-130206 A  (Mitsubishi Electric Corp.),<br>11 June 2009 (11.06.2009),<br>paragraphs [0015] to [0018]; table 1,<br>specifications 3, 7, 8<br>& US 2009/0135878 A1    & CN 101447640 A<br>& KR 10-2009-0054366 A | 2-6 |

☐ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 January, 2011 (07.01.11) | 25 January, 2011 (25.01.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008172141 A
- JP 2006344743 A